# EUROPÄISCHE PATENTSCHRIFT

(11) **EP 2 289 075 B1**
(45) Veröffentlichungstag und Bekanntmachung des Hinweises auf die Patenterteilung: **06.09.2017**
(21) Anmeldenummer: 09749929.7
(22) Anmeldetag: 22.05.2009
(51) Int. Cl.: H05K 1/02, H05K 1/18, H01C 7/10, H01C 1/084, H01C 7/12

(54) **ELEKTRISCHE BAUELEMENTANORDNUNG MIT VARISOR UND HALBLEITERBAUELEMENT**
ELECTRIC COMPONENT ASSEMBLY COMPRISING A VARISTOR AND A SEMICONDUCTOR COMPONENT
ENSEMBLE COMPOSANT ÉLECTRIQUE COMPORTANT UNE VARISTANCE ET UN COMPOSANT À SEMICONDUCTEURS

(30) Priorität: 21.05.2008 DE 102008024480
(43) Veröffentlichungstag der Anmeldung: 02.03.2011
(73) Patentinhaber: Epcos AG, 81669 München (DE)
(72) Erfinder: FEICHTINGER, Thomas, A-8010 Graz (AT); ENGEL, Günter, A-8430 Leibnitz (AT); PECINA, Axel, A-8543 St. Martin (AT)
(74) Vertreter: Epping - Hermann - Fischer
(86) Internationale Anmeldenummer: PCT/EP2009/056251
(87) Internationale Veröffentlichungsnummer: WO 2009/141439

(56) Entgegenhaltungen:
- EP-A- 1 580 809
- WO-A-2005/001943
- JP-A- 5 072 567
- JP-A- 2008 028 029

## Beschreibung

Es wird eine elektrische Bauelementanordnung beschrieben, die wärmeableitende Mittel für ein Halbleiterbauelement umfasst.

Aus DE 10 2007 013 016 A1 und aus EP 1 580 809 A2 ist ein Varistorbauelement mit Wärmeleitern bekannt. Auf dem Varistorbauelement ist nach einer Ausführung eine lichtemittierende Diode angeordnet. Eine zu lösende Aufgabe besteht darin, wärmeableitende Mittel für ein elektrisches Bauelement in einer Anordnung anzugeben. Die Aufgabe wird erfindungsgemäß durch eine elektrische Bauelementanordnung mit den Merkmalen des Anspruchs 1 gelöst.

Es wird eine elektrische Bauelementanordnung mit einem Halbleiterbauelement und einem Träger angegeben, wobei der Träger eine gut wärmeleitende Keramik enthält und mit zumindest einem Varistorkörper verbunden ist. Dabei ist Wärme vom Halbleiterbauelement zumindest teilweise über den Varistorkörper zum Träger ableitbar. Im Folgenden wird der Träger auch als Wärmesenke bezeichnet.

Als gut wärmeleitende Keramiken der Wärmesenke haben sich zum Beispiel Aluminiumnitrid, Siliziumkarbid, Hafniumoxid und Manganoxid herausgestellt, die entsprechend vorzugsweise in der Wärmesenke enthalten sind. Eine gut wärmeleitende Keramik der Wärmesenke kann als Matrix gebildet sein, in der ein gut wärmeleitender Füllstoff aufgenommen ist, wie zum Beispiel Metall. So sind nach einer Ausführungsform Metallpartikel als Füllstoff in der bereits gut wärmeleitenden keramischen Matrix der Wärmesenke enthalten. Diese Maßnahme erhöht die gesamte Wärmeleitfähigkeit der Wärmesenke noch weiter.

Darüber hinaus kann die Wärmesenke zumindest einen wärmeleitenden Kanal aufweisen, der eine vom umliegenden Material des Trägers verschiedene Materialbeschaffenheit aufweist. Insbesondere wird bevorzugt, dass der wärmeleitende Kanal eine höhere Wärmeleitfähigkeit aufweist, als das umliegende Material. Der wärmeleitende Kanal kann dabei ein Metall oder eine gut wärmeleitende Keramik enthalten.

Die Wärmesenke ist nach einer Ausführungsform als Platte bzw. als starre Unterlage ausgeführt.

Die Wärmesenke weist gemäß einer Ausführungsform mehrere elektrische Anschlüsse auf, die zur Kontaktierung mit einem mit der Wärmesenke verbundenem Bauelement, wie zum Beispiel das Halbleiterbauelement oder der Varistorkörper, dienen. Die elektrischen Anschlüsse sind nach einer Ausführungsform als elektrisch leitende Schichten ausgeführt. Beispielsweise sind nach einer Ausführungsform elektrische Leiterbahnen auf der Wärmesenke angeordnet. Diese können jeweils mehrfach richtungsändernde Verläufe aufweisen bzw. als flächige, geometrische Muster realisiert sein. Sie können mittels Siebdrucken auf die Wärmesenke aufgebracht sein. Ist die Wärmesenke als Platte bzw. als starre Unterlage ausgeführt, so können die elektrischen Anschlüsse auf sich gegenüber liegenden Oberflächen der Platte angeordnet sein. Die mehreren elektrischen Anschlüsse der Wärmesenke umfassen vorzugweise Anoden, Kathoden und / oder Massekontakte, wobei nach einer Ausführungsform ein Massekontakt der Wärmesenke mit demjenigen des Varistorkörpers kontaktiert ist. Anoden bzw. Kathodenkontakte der Wärmesenke können entsprechende Kontakte des Varistorkörpers bzw. des Halbleiterbauelement kontaktieren.

Das Halbleiterbauelement weist nach einer Ausführungsform auf seiner auf der Wärmesenke liegenden Unterseite elektrische Außenkontakte auf, welche mit den elektrischen Anschlüssen der Wärmesenke kontaktiert sind. Dabei wird bevorzugt, dass die elektrischen Außenkontakte des Halbleiterbauelements als Lotkugeln, insbesondere als Flipchipkontaktierung ausgeführt sind. Derartige elektrische Außenkontakte erleichtern die Montage des Halbleiterbauelements auf der Wärmesenke erheblich.

Die Wärmesenke weist nach einer vorteilhaften Ausführungsform elektrische Durchkontaktierungen auf, welche beispielsweise mit gegebenenfalls auf der Wärmesenke aufgebrachten Leiterbahnstrukturen verbunden sind. So kann eine elektrische Kontaktierung des Halbleiterbauelements und / oder des Varistorkörpers durch die Wärmesenke beispielsweise zu einer Leiterplatte hindurchgeführt werden.

Die Wärmesenke kann mehrere übereinander angeordnete Schichten umfassen, zwischen denen beispielsweise Leiterbahnen verlaufen, die mit Durchkontaktierungen der Wärmesenke verbunden sein könnten. Bei den Schichten kann es sich um dielektrische Schichten, insbesondere um gut wärmeleitende Keramikschichten handeln. Die Schichten können miteinander versintert sein, wobei eine monolithische keramische Platte gebildet wird.

Gemäß einer Ausführungsform der elektrischen Bauelementanordnung ist der Varistorkörper als Bauelement ausgeführt und auf der Wärmesenke montiert, wobei das Halbleiterbauelement seinerseits auf dem Varistorkörper montiert ist.

Der Varistorkörper enthält vorzugsweise ein Kompositmaterial, das zumindest aus einer Varistorkeramik und einem gut wärmeleitenden Material zusammengesetzt ist, wobei das gut wärmeleitende Material sich von der Varistorkeramik, die hauptsächlich zur nichtlinearen Widerstandsfunktion des Varistorkörpers gewählt ist, unterscheidet. Geeignete Rezepturen für eine als Matrix gebildete Varistorkeramik sind beispielsweise die Verbindungen Zinkoxid - Wismut - Antimon oder Zinkoxid - Praseodym.

Gemäß einer Ausführungsform ist die Varistorkeramik als Hauptkomponente bzw. als Matrix des Kompositmaterials und das wärmeleitende Material als Füllstoff in dieser Matrix gebildet. Ein Beispiel eines gut wärmeleitenden Füllstoffs ist ein Metall.

Der Füllstoff liegt vorzugsweise als eine Verteilung von gut wärmeleitenden Partikeln im Varistorkörper vor. Als geeignete Metalle sind insbesondere Metalle mit einer Wärmeleitfähigkeit größer 100 W/(m*K) und/oder Edelmetalle der 2. und 3. Übergangsmetallperiode bzw. deren Legierungen zu nennen. Das als Füllstoff vorliegende Metall ist vorzugsweise gewählt aus Silber (Ag), Palladium (Pd), Platin (Pt), Wolfram (W), Legierungen dieser Elemente oder Mischungen der vorgenannten Stoffe. Als Legierungen kommen Legierungen der genannten Metalle untereinander und/oder mit anderen Elementen in Betracht; beispielsweise sind Silber-Palladium-Legierungen zu nennen.

Ein vorzugsweise als Füllstoff in der Varistorkeramik vorliegendes Metall hat den Vorteil, dem Varistorkörper eine höhere Wärmeleitfähigkeit zu verleihen, so dass Wärme vom Varistorkörper selbst zur Wärmesenke abgeleitet werden kann.

Auch kann über die elektrischen Anschlüsse zwischen dem Halbleiterbauelement und dem Varistorkörper laufende Wärme über den besonders wärmeleitfähig ausgeführten Varistorkörper zur Wärmesenke abgeleitet werden.

Vorteilhaft ist eine Ausführungsform, bei der der Varistorkörper eine gut wärmeleitende Keramik enthält, die sich von der Varistorkeramik unterscheidet bzw. eine höhere Wärmeleitfähigkeit aufweist, als die Varistorkeramik. Als geeignete Keramiken haben sich zum Beispiel Aluminiumnitrid, Siliziumcarbid, Hafniumoxid und Manganoxid herausgestellt, insbesondere auch deshalb, weil sie sich mit einer bevorzugten Varistorkeramik wie zum Beispiel Zinkoxid gut versintern lassen, ohne dass sich unerwünschte kristalline Unterbrechungen im Varistorkörper ausbilden. Die zusätzliche, gut wärmeleitende Keramik kann ähnlich wie beim Metall als Füllstoff in der als Matrix ausgeführten Varistorkeramik vorliegen.

Der Füllstoff im Varistorkörper liegt beispielsweise als eine vorzugsweise möglichst homogene Verteilung von gut wärmeleitenden Partikeln vor.

Der Varistorkörper kann als Vielschichtvaristor mit einem Stapel von Varistorkeramikschichten und zumindest bereichsweise dazwischenliegenden Innenelektrodenschichten ausgeführt sein. Es wird bevorzugt, dass der Vielschichtvaristor ein gesintertes, monolithisches Vielschichtbauelement ist. Als Varistorkeramik der einzelnen Schichten wird vorzugsweise hauptanteilig Zinkoxid gewählt, wobei die Innenelektroden Silber, Palladium, Platin, Kupfer, Nickel oder eine Legierung dieser Materialien enthalten können.

Nach einer Ausführungsform können ein oder mehrere Schichten eines als Vielschichtvaristor ausgebildeten Varistorkörpers Zirkonoxid aufweisen. Dabei wird bevorzugt, dass zumindest die Grundschicht des Vielschichtvaristors, die auf der keramischen Wärmesenke liegt, Zirkonoxid enthält. Dadurch können die Einflüsse von Streukapazitäten des Vielschichtvaristors auf die keramische Wärmesenke und der gegebenenfalls auf der keramischen Wärmesenke vorhandenen Leiterbahnen reduziert werden. Auch die Deckschicht des Vielschichtvaristors könnte als eine Zirkonoxid enthaltende Schicht ausgeführt sein. Das könnte von Vorteil sein, wenn auf dem Varistorkörper ein weiteres Bauelement angeordnet ist, das von Streukapazitäten ungestört bleiben soll.

Anstelle eines Vielschichtvaristors kann der Varistorkörper als Bulkvaristor ausgeführt sein. Dieser weist einen einzigen Varistorblock auf, an dessen Außenseite gegenpolige Außenkontakte vorhanden sind. Der Varistorblock ist im Innern jedoch frei von metallischen Schichten.

Gemäß einer Ausführungsform weist der Varistorkörper mehrere elektrische Anschlüsse auf, von denen zumindest ein erster elektrischer Anschluss das Halbleiterbauelement kontaktiert. Dieser elektrische Anschluss ist vorzugsweise als metallische Schicht auf dem Varistorkörper ausgeführt. Die metallische Schicht kann auf zumindest einem Bereich der Oberseite des Varistorkörpers aufgebracht sein, beispielsweise mittels Siebdrucken. Die elektrischen Anschlüsse sind vorzugsweise bondbar.

Die mehreren elektrischen Anschlüsse können mit einem Kontaktdraht und / oder mit einer Leiterbahn auf der Wärmesenke verbunden sein.

Gemäß einer Ausführungsform der Bauelementanordnung umfassen die mehreren elektrischen Anschlüsse des Varistorkörpers zumindest einen vom ersten elektrischen Anschluss separaten, zweiten elektrischen Anschluss, der den Varistorkörper nach außen kontaktiert, welches bedeutet, dass der Varistorkörper mit diesem zweiten elektrischen Anschluss mit einem vom Halbleiterbauelement getrennten zweiten elektrischen Potential verbunden ist. Es kann sich bei einem zweiten elektrischen Anschluss beispielsweise um einen Masseanschluss handeln. Dabei kann der zweite elektrische Anschluss mit einer Leiterbahn auf einer Leiterplatte kontaktiert sein.

Sowohl ein erster elektrischer Anschluss als auch ein zweiter elektrischer Anschluss können als metallische Schichten ausgeführt sein. Als metallische Schichten ausgeführte elektrische Anschlüsse des Varistorkörpers können zumindest eines der folgenden Materialien enthalten: Gold, Nickel, Chromium, Palladium, Zinn.

Gemäß einer Ausführungsform der Bauelementanordnung ist der zweite elektrische Anschluss, der den Varistorkörper nach außen kontaktiert, auf der Unterseite des Varistorkörpers, d.h., auf der der Montagefläche des Halbleiterbauelements senkrecht gegenüberliegenden Fläche, angeordnet. Der zweite elektrische Anschluss kann beispielsweise als Bondpad ausgeführt sein.

Nach einer Ausführungsform ist es vorgesehen, dass der zweite elektrische Anschluss vom ersten elektrischen Anschluss beabstandet auf der Oberseite des Varistorkörpers angeordnet ist. Dabei könnten beide Anschlüsse Kontaktdrähte umfassen, die den Varistorkörper mit dem Halbleiterbauelement bzw. mit der Masse verbinden.

Nach einer Ausführungsform ist es vorgesehen, dass der erste elektrische Anschluss des Varistorkörpers, der das Halbleiterbauelement kontaktiert, gleichzeitig einen Kontakt des Varistorkörpers nach außen bildet, gegebenenfalls unter Verwendung eines mit dem ersten elektrischen Anschluss verwendeten Kontaktdrahtes.

Gemäß einer Ausführungsform weist der Varistorkörper zumindest eine Innenelektrode auf, die zur Abstimmung der Kapazität des Varistorkörpers dienen kann. Die Innenelektrode kann zwischen den Schichten eines Schichtstapels des Varistorkörpers angeordnet sein. Es kann sich bei der Innenelektrode um eine Masseelektrode handeln, welche Überspannungen bzw. Stoßströme durch den Varistor bzw. vom Varistorkörper ableitet. Die Innenelektrode ist mit zumindest einem elektrischen Anschluss des Varistorkörpers verbundeneine mechanische Kontaktierung ist dabei jedoch nicht zwingend erforderlich. Die Innenelektrode könnte daher im Innern des Varistorkörpers "schwebend" angeordnet sein. Alternativ ist die Innenelektrode mittels zumindest einer Durchkontaktierung, auch als Via zu bezeichnen, mit dem zumindest einen elektrischen Anschluss verbunden.

Gemäß einer Ausführungsform sind mehrere Innenelektroden im Varistorkörper vorhanden und kontaktieren unterschiedliche elektrische Anschlüsse des Varistorkörpers. Die Innenelektroden können schwebend oder nach außen kontaktiert ausgeführt sein. Es wird bevorzugt, dass sie mittels einer Varistorkeramik bzw. mittels eines Dielektrikums voneinander getrennt sind und in Stapelrichtung gemeinsame Überlappflächen aufweisen, durch die Kapazitäten erzeugbar sind. Die Innenelektroden verlaufen gemäß einer Ausführungsform senkrecht zur Montagefläche des Halbleiterbauelements. Dabei kann der Varistorkörper mit einer Längsseite auf der Wärmesenke liegen, d.h., die Stapelrichtung des Varistorkörpers verläuft parallel zur Ebene der Wärmesenke bzw. zur Montageebene eines auf dem Varistorkörper montierten Halbleiterbauelements.

Mit einem gemeinsamen elektrischen Anschluss kontaktierte Innenelektroden des Varistorkörpers können jeweils auf derselben Ebene liegen, wie Innenelektroden, die mit einem anderen gemeinsamen elektrischen Anschluss des Varistorkörpers kontaktiert sind. Kapazitäten zwischen den Inneneletroden werden in diesem Falle zwischen den einander zugewandten Enden von Innenelektroden, die auf derselben Ebene im Varistorkörper vorliegen, erzeugt. Gegenpolige Innenelektroden überlappen sich in orthogonaler Projektion bei einer solchen Ausführungsform nicht.

Gemäß einer Ausführungsform der Bauelementanordnung ist das Halbleiterbauelement auf der Wärmesenke montiert. Dabei wird bevorzugt, dass es auf seiner auf der Wärmesenke liegenden Unterseite elektrische Außenkontakte aufweist, welche mit elektrischen Leiterbahnen auf der Wärmesenke kontaktiert sind. Es wird bevorzugt, dass diese elektrischen Außenkontakte des Halbleiterbauelements als Lotkugeln, insbesondere als Flipchipkontaktierung ausgeführt sind. Derartige elektrische Außenkontakte erleichtern die Montage des Halbleiterbauelements auf der Wärmesenke.

Bei einer Ausführungsform der Bauelementanordnung, bei der das Halbleiterbauelement auf der Wärmesenke montiert ist, kann der Varistorkörper in der Wärmesenke integriert sein. Durch die Integration des Varistorkörpers der Wärmesenke ist der Varistorkörper mit der Wärmesenke verbunden, sowohl mechanisch als auch thermisch, gegebenenfalls auch elektrisch, sofern der Varistorkörper mit elektrischen Anschlüssen der Wärmesenke verbunden ist. Somit wird eine hochkompakte Anordnung einer Wärmesenke, eines Varistorkörpers und eines Halbleiterbauelements geboten.

Dabei ist der in der Wärmesenke integrierte Varistorkörper vorzugsweise mit einem ersten und mit einem zweiten elektrischen Anschluss, wobei diese Anschlüsse beispielsweise auf sich gegenüberliegenden Oberflächen der Wärmesenke angeordnet sein können, verbunden. Beim ersten elektrischen Anschluss kann es sich dabei um einen elektrischen Anschluss zum Halbleiterbauelement und beim zweiten elektrischen Anschluss um einen Masseanschluss handeln. Der Varistorkörper kann als Via in der Wärmesenke ausgeführt sein. Er kann dabei von einer dem Halbleiterbauelement zugewandten Oberfläche zur gegenüberliegenden Oberfläche verlaufen. In der Wärmesenke können mehrere solche so genannte Varistor-Vias integriert sein. Ein Varistor-Via kann als eine mit einem Varistormaterial gefüllte Bohrung der Wärmesenke ausgeführt sein.

Gemäß einer Ausführungsform ist auf der Wärmesenke lateral neben dem Halbleiterbauelement ein weiteres Bauelement, beispielsweise ein Thermistor, angeordnet, das mittels elektrischer Anschlüsse der Wärmesenke kontaktiert werden kann. Beim weiteren Bauelement kann es sich um ein Halbleiterbauelement der in diesem Dokument beschriebenen Art oder um ein anderes elektrisches Bauelement handeln. In jedem Falle ist die Wärmesenke in der Lage, Wärme von allen auf der Wärmesenke angeordneten Bauelementen abzuleiten. Ist mit dem weiteren Bauelement auch ein Varistorkörper kontaktiert, so kann das weitere Bauelement darüber hinaus vor Überspannungen geschützt werden.

Bevorzugt wird eine Bauelementanordnung mit einem Gehäuse in bzw. an dem die Wärmesenke angeordnet ist. Es wird bevorzugt, dass das Gehäuse zumindest einen elektrisch leitenden Teil oder Bereich aufweist, der mit dem Varistorkörper und / oder mit dem Halbleiterbauelement kontaktiert ist. Das Gehäuse trägt die Wärmesenke, wobei das Halbleiterbauelement und der Varistorkörper mit dem elektrisch leitenden Teil des Gehäuses parallel verschaltet sind. Der elektrisch leitende Teil des Gehäuses kann speziell als metallische Schicht, beispielsweise als Leiterbahn ausgeführt sein. Der elektrisch leitende Teil des Gehäuses enthält vorzugsweise Aluminium oder Kupfer.

Das Gehäuse weist nach einer Ausführungsform mehrere voneinander mittels einer Isolierung elektrisch entkoppelte, elektrisch leitende Bereich, die mit gleichpoligen elektrischen Anschlüssen des Halbleiterbauelements, des Varistorkörpers und / oder der Wärmesenke kontaktiert sind.

Gemäß einer Ausführungsform weist das Gehäuse zumindest einen wärmeleitenden Bereich auf, der thermisch mit dem Träger und / oder mit dem Varistorkörper gekoppelt ist. Dadurch kann vom Varistorkörper bzw. vom Träger aufgenommene Wärme durch das Gehäuse abgeleitet werden. Dabei kann dieser wärmeleitende Bereich des Gehäuses ein gut wärmeleitendes Material, wie zum Beispiel eine gut wärmeleitende Keramik oder ein Metall aufweisen.

Gemäß einer günstigen Ausführungsform der Bauelementanordnung weist sie zusätzlich einen Thermistor auf, der mit dem Halbleiterbauelement verschaltet ist. In Abhängigkeit seiner Widerstands / Temperaturkennlinie trägt der Thermistor zur Regulierung des Steuerstroms des Halbleiterbauelements bei, sodass dieser schonend betrieben werden kann. Der Thermistor ist gemäß einer Ausführungsform auf dem Varistorkörper montiert, muss es aber nicht sein. Stattdessen könnte er auf dem Träger bzw. auf der Wärmesenke neben dem Halbleiterbauelement angeordnet sein oder getrennt vom Träger in einem gemeinsamen Gehäuse.

Das Halbleiterbauelement kann aus einer Vielzahl von Bauelementen gewählt sein. Es kann ein optoelektronisches Bauelement, wie z.B. eine LED, ein Kondensator bzw. ein Vielschichtkondensator, ein Thermistor bzw. ein Vielschichtthermistor mit PTC oder NTC Eigenschaften, eine Diode oder ein Verstärker sein. In jedem Falle ist der Varistorkörper in der Lage, das mit ihm kontaktierte Halbleiterbauelement vor Überspannungen schonend zu schützen und sogar nach einigen in diesem Dokument beschriebenen Ausführungsformen in der Lage, Wärme vom Halbleiterbauelement abzuleiten. Auch ist in jedem Falle eine Wärmesenke vorhanden, die Wärme vom Halbleiterbauelement ableiten kann.

Eine LED als Halbleiterbauelement ist zusammengesetzt vorzugsweise aus einem oder mehreren der folgenden Materialien: Galliumphosphid (GaP), Galliumnitrid (GaN), Galliumarsenphosphid (GaAsP), Aluminiumgalliumindiumphosphid (AlGaInP), Aluminiumgalliumphosphid (AlGaP), Aluminiumgalliumarsenid (AlGaAs), Indiumgalliumnitrid (InGaN), Aluminiumnitrid (AlN), Aluminiumgalliumindiumnitrid (AlGaInN), Zinnselenid (ZnSe).

Die Bauelementanordnung mit der keramischen Wärmesenke hat den Vorteil, als Einzelprodukt gewerblich verwertbar zu sein.

Die beschriebenen Gegenstände werden anhand der folgenden Figuren und Ausführungsbeispiele näher erläutert.

Dabei zeigt:
- Figur 1: eine Querschnittsansicht einer Bauelementanordnung mit einem auf einer Wärmesenke montierten Halbleiterbauelement,
- Figur 2: eine Querschnittsansicht einer Bauelementanordnung mit einem auf einer Wärmesenke montierten Halbleiterbauelement und einem zwischen diesen angeordneten Varistorchip,
- Figur 3: eine Bauelementanordnung gemäß Figur 2 mit einer möglichen Ausgestaltung des Innenlebens des Varistorchips,
- Figur 4: eine Bauelementanordnung gemäß Figur 2 mit einer möglichen Ausgestaltung des Innenlebens der Wärmesenke sowie mit einem zusätzlichen Bauelement, das auf der Wärmesenke montiert ist,
- Figur 5: eine Bauelementanordnung mit einem auf einer Wärmesenke montierten Halbleiterbauelement sowie einem Gehäuse.

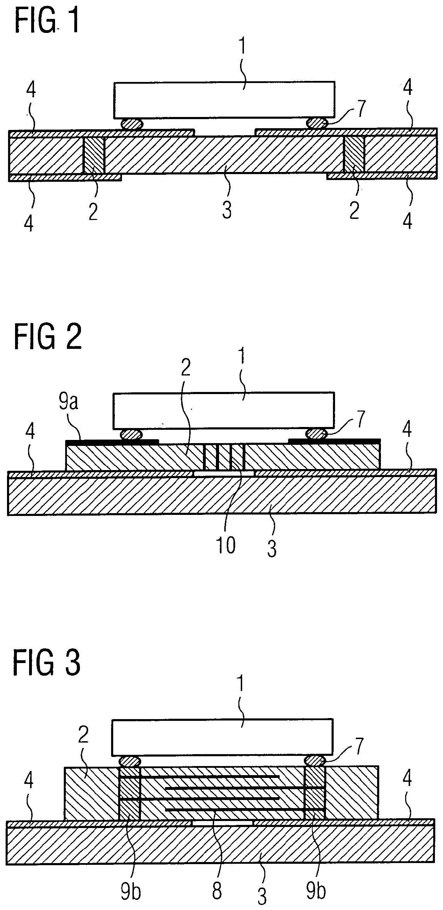

Figur 1 zeigt eine optoelektronische Bauelementanordnung, bei der ein Halbleiterbauelement 1, wie zum Beispiel eine LED, auf einer als Träger ausgeführten Wärmesenke 3 angeordnet ist. Ein elektrischer Kontakt zwischen der Wärmesenke 3 und dem Halbleiterbauelement 1 ist mittels einer auf der Unterseite der LED befindlichen Flipchipkontaktierung 5 und mittels elektrischer Anschlüsse 4 der Oberseite der Wärmesenke 3 erreicht. Die elektrischen Anschlüsse 4 sind voneinander auf der Oberseite der Wärmesenke beabstandet und jeweils beispielsweise als Kontaktpad bzw. als metallische Schicht ausgeführt. Auf jedem elektrischen Kontakt 4 der Oberseite der Wärmesenke 3 kann eine Lotkugel der Flipchipkontaktierung 5 des Halbleiterbauelements 1 angeordnet sein.

Die Wärmesenke 3 selbst ist als keramische Platte ausgeführt. Diese wird ober- und unterseitig mit voneinander beabstandeten metallischen Schichten 4, beispielsweise als Leiterbahnen, versehen, um mit getrennten elektrischen Polen ein auf der Wärmesenke angeordnetes Halbleiterbauelement zu kontaktieren. Die metallische Schichten 4 enthalten beispielsweise Aluminium.

Die auf sich gegenüberliegen Oberflächen der beispielsweise Aluminiumnitrid enthaltenden, gut wärmeleitenden, keramischen Platte 3 aufgebrachten elektrischen Anschlüsse 4 sind mittels jeweils eines in der Platte 3 integrierten Varistor-Vias 2 miteinander verbunden. Das jeweilige Varistor-Via enthält beispielsweise Zinkoxid als Matrix und kann mit einer wärmeleitenden Keramik und / oder mit einem Metall, jeweils als Füllstoff, angereichert sein, wodurch die Wärmeleitfähigkeit des Varistorkörpers erhöht wird.

Auf der Unterseite der Wärmesenke angeordnete elektrische Anschlüsse 4 können Masseanschlüsse sein, die die jeweiligen Varistorvias 3 mit einer Masse kontaktieren. Oberseitige elektrische Anschlüsse der Wärmesenke 3, die mit dem Halbleiterbauelement kontaktiert sind, können als Anoden bzw. Kathodenkontakte ausgeführt sein.

Figur 2 zeigt eine optoelektronische Bauelementanordnung, bei der ein als Chip ausgeführter Varistorkörper 2 auf oberseitige elektrische Kontakten 4 der keramischen Platte 3 angeordnet ist. Der Varistorchip 2 kann wie bei der in Figur 1 gezeigten LED unterseitig eine Flipchipchipkontaktierung aufweisen (nicht gezeigt), die die metallischen Schichten 4 der Wärmesenke kontaktiert. Oberseitig ist der Varistorchip 2 seinerseits mit elektrischen Anschlüssen 9a in der Form von metallischen Schichten versehen, die die unterseitigen elektrischen Anschlüsse 5 der auf dem Varistorchip 2 montierten LED 1 kontaktieren. Bei diesen Anschlüssen kann es sich um Anoden oder Kathodenanschlüsse handeln. Der Varistorchip 2 kann als Bulkvaristor ausgeführt sein, wobei er einen einstückigen Grundkörper (ohne Schichten) aus einer Varistorkeramik und wahlweise weiteren Zusätzen der in diesem Dokument beschriebenen Art zur verbesserten Wärmeleitfähigkeit umfasst. Der Varistorkörper ist mit wärmeleitenden Kanälen 10 ausgestattet (diese sind jedoch optional), die senkrecht zur Montagefläche der LED 1 durch sein Inneres verlaufen. Die wärmeleitenden Kanäle 10 können als mit Metall gefüllte Bohrungen ausgeführt sein oder als mit einer gut wärmeleitenden Keramik gefüllte Bohrung, wobei diese wärmeleitende Keramik eine höhere Wärmeleitfähigkeit aufweist, als die der umliegenden Varistorkeramik.

Figur 3 zeigt eine Anordnung von Bauelementen gemäß Figur 2 mit dem Unterschied, dass der Varistorkörper 2 als monolithisch gesinterter Vielschichtvaristor ausgeführt ist, der einen Stapel von laminierten keramischen und Elektrodenschichten bzw. Innenelektroden 8 umfasst. Die Innenelektroden 8 eines jeden Innenelektrodensatzes, d.h., eines jeden Satzes von gleichpoligen Innenelektroden, kontaktieren jeweils eine für diese Innenelektroden gemeinsame, im Vielschichtvaristor 2 integrierte Durchkontaktierung 9b. Die Durchkontaktierung 9b verläuft von der Oberseite des Vielschichtvaristors 2 zur Unterseite und bildet auf jeder Oberfläche des Vielschichtvaristors eine elektrische Anschlussfläche, die mit einem weiteren Bauelement bzw. mit einem elektrischen Anschluss kontaktiert werden kann. Beispielsweise sitzt eine Lotkugel einer Flipchipkontaktierung 7 der LED 1 direkt auf der exponierten Endfläche der Durchkontaktierung 9b des Varistorkörpers. An der Unterseite des Varistorkörpers 2 sitzt eine Endfläche der Durchkontaktierung 9b auf einer auf der keramischen Platte 3 aufgebrachten metallischen Schicht 4. Die Durchkontaktierung 9b kann somit auch als Außenkontakt des Varistorkörpers 2 dienen.

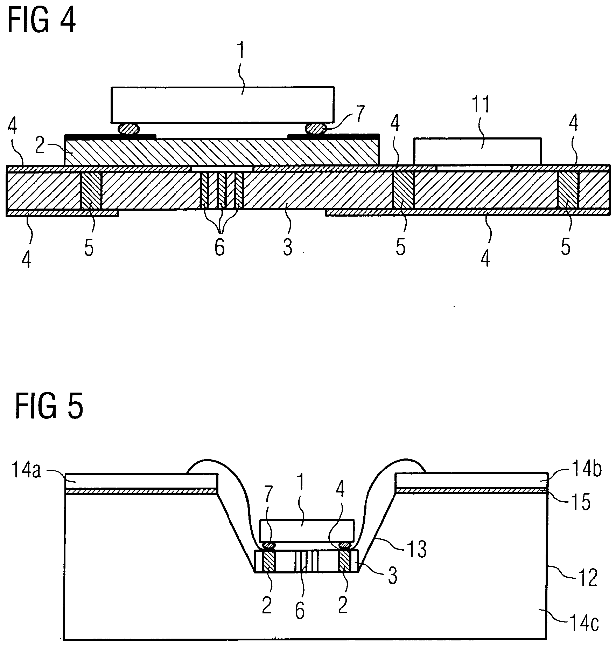

Figur 4 zeigt eine optoelektronische Bauelementanordnung, bei der ein Varistorchip 2, auf dem eine LED montiert ist, auf einer gut wärmeleitenden keramischen Platte 3 montiert ist. Neben dem Varistorchip ist mit einem Abstand ein weiteres Bauelement 11, beispielsweise ein Thermistor, auf der keramischen Platte 3 angeordnet. Der Thermistor 11 und der Varistorchip 2 sind zum Teil mit demselben als metallische Schicht ausgeführten elektrischen Anschluss 4 der Oberseite der keramischen Platte 3 kontaktiert. Der Thermistor kann ebenfalls unterseitig eine Flipchipkontaktierung aufweisen. Der Thermistor wird in Abhängigkeit seiner Temperatur- und Widerstandskennlinie dazu verwendet, den Steuerstrom der LED bzw. des Halbleiterbauelements zu regulieren. Dabei kann der Thermistor mit einer Auswerteeinheit verbunden sein, die gemessene Werte des Thermistors verwendet um den das Halbleiterbauelement speisenden Strom zu regulieren. Die Regulierung des Steuerstroms erfolgt derart, dass die LED keinen Stoßströmen ausgesetzt wird bzw. unter möglichst konstantem Wechselstrom betrieben wird.

Die wärmeleitende, keramische Platte 3 weist mehrere elektrische Durchkontaktierungen 5 auf, die auf gegenüberliegenden Oberflächen der keramischen Platte 3 aufgebrachte elektrische Anschlüsse 4 kontaktieren. Auch sind in der keramischen Platte 3 senkrecht zur Auflagefläche des Varistorchips 2 mehrere thermische Vias als wärmeleitende Kanäle 6 vorhanden, die ebenfalls senkrecht zur Auflagefläche des Varistorchips 2 auf der keramischen Platte 3 verlaufen. Ein thermisches Via 6 kann als eine mit einem Metall oder mit einer gut wärmeleitenden Keramik gefüllte Bohrung der keramischen Platte ausgeführt sein.

Figur 5 zeigt eine optoelektronische Bauelementanordnung umfassend eine gut wärmeleitende keramische Platte 3 als Träger einer LED 1, wobei der Träger 3 mit einem Varistorkörper 2 verbunden ist, der als Varistor-Via im Träger integriert ist. Die Bauelementanordnung weist ein Gehäuse 12 auf, in dessen Vertiefung 13 die keramische Platte 3 auf einem Boden aufliegt. Das Halbleiterbauelement 1, der Varistorkörper 2 sowie die keramische Wärmesenke 3 können bezüglich ihrer Anordnung sowie bezüglich ihrer jeweiligen Konstruktion nach einem der in diesem Dokument beschriebenen Art ausgeführt sein.

Die Vertiefung 13 des Gehäuses 12 weist vorzugsweise auf ihrer dem Licht der LED exponierten Oberfläche eine reflektive Beschichtung auf. Dadurch kann die gesamte Lichtauskopplung von der Bauelementanordnung vergrößert werden. Unterseitige elektrische Anschlüsse der keramischen Platte 3, wie sie im Detail auch mit der Figur 1 gezeigt werden, sind mit einem entsprechenden elektrischen Anschluss 14c des Gehäuses 12, der beispielsweise ein Masseanschluss ist, kontaktiert. Der Masseanschluss 14c ist von einem Kathodenanschluss 14b und vom einem Anodenanschluss 14a des Gehäuses 12 mittels einer Isolierung 15, beispielsweise eine im Gehäuse integrierte Isolierschicht, elektrisch entkoppelt. Der Anodenanschluss 14a und der Kathodenanschluss 14b des Gehäuses 12 können mit den entsprechenden Anschlüssen des Halbleiterbauelements 1 bzw. des Varistorkörpers 2 beispielsweise mittels Kontaktdrähten verbunden sein. Der Bereich des Gehäuses 12, der als Massenanschluss 14c dient bzw. mit dem Varistorkörper 2 kontaktiert ist, kann beispielsweise aus einem Metall wie z.B. Kupfer oder Aluminium bestehen. Insbesondere wird ein Metall bevorzugt, dass mit geringem Widerstand elektrisch leitend ist und eine hohe Reflektivität für eine verbesserte Lichtauskopplung aufweist.

Vorzugsweise ist die Wärmesenke 3 mit einem gut wärmeleitenden Bereich des Gehäuses 12 mechanisch verbunden, in jedem Fall jedoch thermisch mit ihm gekoppelt, damit das Gehäuse von der Wärmesenke aufgenommene Wärme, welche vom Varistorkörper 2 und / oder vom Halbleiterelement 1 stammt bzw. von diesen abgegeben wird, weiter nach außen ableiten kann.

### Bezugszeichenliste

- 1: Halbleiterbauelement
- 2: Varistorkörper
- 3: Träger bzw. Wärmesenke
- 4: elektrischer Anschluss des Trägers
- 5: Durchkontaktierung des Trägers
- 6: wärmeleitender Kanal des Trägers
- 7: elektrischer Anschluss des Halbleiterbauelements
- 8: Innenelektrode des Varistorkörpers
- 9a: Außenkontakt des Varistorkörpers
- 9b: Durchkontaktierung des Varistorkörpers
- 10: wärmeleitender Kanal des Varistorkörpers
- 11: weiteres elektrisches Bauelement
- 12: Gehäuse
- 13: Vertiefung des Gehäuses
- 14a: erster elektrisch leitender Bereich des Gehäuses
- 14b: zweiter elektrisch leitender Bereich des Gehäuses
- 14c: dritter elektrisch leitender Bereich des Gehäuses
- 15: Isolierschicht

## Patentansprüche

1. Elektrische Bauelementanordnung, aufweisend ein Halbleiterbauelement (1) und einen Träger (3), der eine wärmeleitende Keramik enthält und der mit zumindest einem Varistorkörper (2) verbunden ist, **dadurch gekennzeichnet, dass** Wärme vom Halbleiterbauelement zumindest teilweise über den Varistorkörper zum Träger (3) ableitbar ist und dass der Träger und/oder der Varistorkörper zumindest einen Wärme leitenden Kanal aufweisen.

2. Bauelementanordnung nach Anspruch 1, bei der der Träger (3) zumindest ein Material enthält, das gewählt ist aus: Aluminiumnitrid, Siliziumkarbid, Hafniumoxid, Manganoxid.

3. Bauelementanordnung nach einem der Ansprüche 1 oder 2, bei der der Träger (3) zumindest einen wärmeleitenden Kanal (3) aufweist, der eine vom umliegenden Material des Trägers verschiedene Materialbeschaffenheit aufweist.

4. Elektrische Bauelementanordnung nach einem der vorhergehenden Ansprüche, bei der der Varistorkörper (2) auf dem Träger (3) montiert ist, wobei das Halbleiterbauelement (1) seinerseits auf dem Varistorkörper montiert ist.

5. Elektrische Bauelementanordnung nach Anspruch 4, bei der der Varistorkörper (2) als Vielschichtvaristor ausgeführt ist.

6. Elektrische Bauelementanordnung nach einem der Ansprüche 4 oder 5, bei der der Varistorkörper (2) zumindest einen wärmeleitenden Kanal (10) umfasst, durch den Wärme vom Halbleiterbauelement (1) zum Träger (2) ableitbar ist.

7. Elektrische Bauelementanordnung nach einem der Ansprüche 1 bis 3, bei der der Varistorkörper (2) im Träger (3) integriert ist.

8. Bauelementanordnung nach einem der vorhergehenden Ansprüche, bei der der Träger (3) mehrere elektrische Anschlüsse (4) aufweist, wobei zumindest ein erster elektrischer Anschluss eine elektrische Verbindung zum Halbleiterbauelement (1) herstellt und zumindest ein zweiter elektrischer Anschluss eine elektrische Verbindung nach außen herstellt.

9. Bauelementanordnung nach Anspruch 8, bei der der Varistorkörper (2) im Träger (3) integriert und mit dem ersten und dem zweiten elektrischen Anschluss des Trägers (3) verbunden ist.

10. Bauelementanordnung nach Anspruch 9, bei der der Varistorkörper (2) als Via ausgeführt ist.

11. Bauelementanordnung nach einem der vorhergehenden Ansprüche, bei der der Varistorkörper (2) ein Kompositmaterial enthält, das zumindest aus einer Varistorkeramik als Matrix und einem wärmeleitenden Material als Füllstoff zusammengesetzt ist.

12. Bauelementanordnung nach einem der vorhergehenden Ansprüche, bei der der Varistorkörper (2) zumindest eine Innenelektrode (8) aufweist.

13. Bauelementanordnung nach einem der vorhergehenden Ansprüche, bei der der Träger (3) in einem Gehäuse (12) integriert ist, wobei das Gehäuse ein mit dem Träger verbundenen, wärmeleitenden Bereich aufweist, der mit dem Träger thermisch gekoppelt ist.

14. Bauelementanordnung nach einem der vorhergehenden Ansprüche, bei der das Halbleiterbauelement (1) gewählt ist aus den Bauelementen: optoelektronisches Bauelement, LED, Kondensator, Vielschichtkondensator, Thermistor, Vielschichtthermistor, Diode, Verstärker.

15. Bauelementanordnung nach einem der vorhergehenden Ansprüche, zusätzlich aufweisend einen Thermistor, der in Abhängigkeit seiner Widerstands / Temperaturkennlinie zur Regulierung des Steuerstroms des Halbleiterbauelements (1) beiträgt.

## Claims

1. Electric component assembly, comprising a semiconductor component (1) and a carrier (3), said carrier containing a thermally conductive ceramic and being connected to at least one varistor body (2), **characterized in that** heat from the semiconductor component can be at least partially dissipated to the carrier (3) by means of the varistor body and **in that** the carrier and/or the varistor body have at least one thermally conductive channel.

2. Component assembly according to Claim 1, wherein the carrier (3) contains at least one material selected from: aluminum nitride, silicon carbide, hafnium oxide, manganese oxide.

3. Component assembly according to either of Claims 1 and 2, wherein the carrier (3) has at least one thermally conductive channel (3) having a material constitution that differs from the surrounding material of the carrier.

4. Electric component assembly according to any of the preceding claims, wherein the varistor body (2) is mounted on the carrier (3), wherein the semiconductor component (1), for its part, is mounted on the varistor body.

5. Electric component assembly according to Claim 4, wherein the varistor body (2) is embodied as a multilayer varistor.

6. Electric component assembly according to either of Claims 4 and 5, wherein the varistor body (2) comprises at least one thermally conductive channel (10) through which heat from the semiconductor component (1) can be dissipated to the carrier (2).

7. Electric component assembly according to any of Claims 1 to 3, wherein the varistor body (2) is integrated in the carrier (3).

8. Component assembly according to any of the preceding claims, wherein the carrier (3) has a plurality of electrical terminals (4), wherein at least one first electrical terminal produces an electrical connection to the semiconductor component (1) and at least one second electrical terminal producing an electrical connection toward the outside.

9. Component assembly according to Claim 8, wherein the varistor body (2) is integrated in the carrier (3) and is connected to the first and the second electrical terminal of the carrier (3).

10. Component assembly according to Claim 9, wherein the varistor body (2) is embodied as a via.

11. Component assembly according to any of the preceding claims, wherein the varistor body (2) contains a composite material composed at least of a varistor ceramic as matrix and a thermally conductive material as filler.

12. Component assembly according to any of the preceding claims, wherein the varistor body (2) has at least one internal electrode (8).

13. Component assembly according to any of the preceding claims, wherein the carrier (3) is integrated in a housing (12), wherein the housing has a thermally conductive region which is connected to the carrier and which is thermally coupled to the carrier.

14. Component assembly according to any of the preceding claims, wherein the semiconductor component (1) is selected from the components: optoelectronic component, LED, capacitor, multilayer capacitor, thermistor, multilayer thermistor, diode, amplifier.

15. Component assembly according to any of the preceding claims, additionally comprising a thermistor which contributes, in a manner dependent on its resistance/temperature characteristic curve, to the regulation of the control current of the semiconductor component (1).

## Revendications

1. Ensemble de composants électriques, présentant un composant semi-conducteur (1) et un support (3), lequel contient une céramique conductrice de chaleur et lequel est raccordé avec tout au moins un corps de varistance (2), **caractérisé en ce que** de la chaleur peut être évacuée, tout au moins en partie par l'intermédiaire du corps de varistance, depuis le composant semi-conducteur jusqu'au support (3), et **en ce que** le support et/ou le corps de varistance présentent tout au moins un canal conducteur de chaleur.

2. Ensemble de composants selon la revendication 1, dans lequel le support (3) contient tout au moins un matériau qui est sélectionné parmi les éléments suivants : du nitrure d'aluminium, du carbure de silicium, de l'oxyde de hafnium, de l'oxyde de manganèse.

3. Ensemble de composants selon l'une des revendications 1 ou 2, dans lequel le support (3) présente tout au moins un canal (3) conducteur de chaleur, lequel présente une propriété de matériau qui est différente du matériau environnant du support.

4. Ensemble de composants électriques selon l'une des revendications précédentes, dans lequel le corps de varistance (2) est monté sur le support (3), dans lequel le composant semi-conducteur (1) est, quant à lui, monté sur le corps de varistance.

5. Ensemble de composants électriques selon la revendication 4, dans lequel le corps de varistance (2) est réalisé sous la forme d'une varistance à couches multiples.

6. Ensemble de composants électriques selon l'une des revendications 4 ou 5, dans lequel le corps de varistance (2) comprend tout au moins un canal (10) conducteur de chaleur, à travers lequel de la chaleur peut être évacuée depuis le composant semi-conducteur (1) jusqu'au support (2).

7. Ensemble de composants électriques selon l'une des revendications 1 à 3, dans lequel le corps de varistance (2) est intégré dans le support (3).

8. Ensemble de composants selon l'une des revendications précédentes, dans lequel le support (3) présente plusieurs connexions (4) électriques, dans lequel tout au moins une première connexion électrique établit une liaison électrique avec le composant semi-conducteur (1) et tout au moins une deuxième connexion électrique établit une liaison électrique vers l'extérieur.

9. Ensemble de composants selon la revendication 8, dans lequel le corps de varistance (2) est intégré dans le support (3) et est raccordé avec la première et la deuxième connexion électrique du support (3).

10. Ensemble de composants selon la revendication 9, dans lequel le corps de varistance (2) est réalisé sous la forme d'un via.

11. Ensemble de composants selon l'une des revendications précédentes, dans lequel le corps de varistance (2) contient un matériau composite, lequel est tout au moins composé à partir d'une céramique de varistance, laquelle se présente sous la forme d'une matrice, et d'un matériau conducteur de chaleur, lequel se présente sous la forme d'une matière de remplissage.

12. Ensemble de composants selon l'une des revendications précédentes, dans lequel le corps de varistance (2) présente tout au moins une électrode intérieure (8).

13. Ensemble de composants selon l'une des revendications précédentes, dans lequel le support (3) est intégré dans un boîtier (12), lequel le boîtier dans présente une zone conductrice de chaleur qui est reliée avec le support, laquelle zone est couplée de manière thermique avec le support.

14. Ensemble de composants selon l'une des revendications précédentes, dans lequel le composant semi-conducteur (1) est sélectionné parmi les éléments de structure suivants : un composant optoélectronique, une diode électroluminescente (DEL), un condensateur, un condensateur à couches multiples, un thermistor, un thermistor à couches multiples, une diode, un amplificateur

15. Ensemble de composants selon l'une des revendications précédentes, présentant en outre un thermistor, lequel contribue à la régulation du courant de commande du composant semi-conducteur (1) en fonction de sa caractéristique de résistance/température.
